# EUROPEAN PATENT APPLICATION

(11) **EP 3 941 167 A1**
(43) Date of publication of application: **19.01.2022**
(21) Application number: 20186540.9
(22) Date of filing: 17.07.2020
(51) Int. Cl.: H05K 3/38, H05K 3/18

(54) **THIN METAL ELECTRODE FILMS, AND MANUFACTURING METHOD THEREOF**

(71) Applicant: BASF SE, 67056 Ludwigshafen am Rhein (DE)
(72) Inventor: SeonWoo, Lee, 16342 Suwon-Si, Gyeonggi-do (KR)
(74) Representative: BASF IP Association

(57) **Abstract**

The invention relates to thin metal electrode films for use in high-performance device systems comprising: a substrate; an underlayer; and a primer layer coated with metal coating. The thin metal electrode film has metal wiring with high resolution on a substrate and thus has excellent electrical properties. The invention also relates to a method for manufacturing thin metal electrode film.

## Description

### TECHNICAL FIELD

The present invention relates to thin metal electrode films for use in high-performance device systems in the field of printed circuit board, sensor devices, and telecommunication devices (i.g., network devices, Wi-Fi, 5G, etc.) and display, and also relates to its manufacturing method.

### BACKGROUND ART

Thin metal electrode films are widely used for printed circuit board, transparent sensors (i.e., metal mesh-based touch sensors), transparent electrodes for display, and antennas for mobile electronics and displays, etc. As one example, thin printed circuit board is a key interconnection component and widely used in various electronics. A conventional method for manufacturing thin metal electrode films include providing a non-conductive substrate, sputtering a metal layer such as Ni-Cr on the substrate, disposing Cu seeds on the metal layer, electroplating a Cu layer and forming fine metal patterns by photolithograph. The method is time-consuming and thus is not capable of producing large amount of thin metal electrode films with high efficiency.

For reducing the manufacturing time, a primer layer is proposed to be used on the substrate. The primer layer, after application, undergoes patterning and thermal baking to form desired pattern, and then Cu is coated on the pattern through electroplating. However, the surface of the substrate generally has defects caused by, for example, scratching by various particles generated during the manufacturing process. Those defects may lead to problems of the final products, such as collapse and peeling-off of deposited metal layer.

EP 3190207A1 has described a primer layer comprising hyperbranched polymer. The primer layer can provide sufficient adhesion to the substrate even if there is no pretreatment with chromium compound.

US 7682774B2 has described a resin composition comprising a catalyst precursor for electroless plating to form an electromagnetic wave shielding layer. By using this resin composition, loss of catalyst during a wet process is substantially prevented and a uniform, fine metal pattern can be obtained with increased plating rate. Technologies in the art mainly focus on adhesion of the primer layer and the metal layer. There is still no satisfactory method for solving problems brought about by surface defects of substrates. Thus, it is desired to provide thin metal electrode film which does not involve such problems.

### CONTENTS OF THE INVENTION

It is an object of the present invention to provide a thin metal electrode film comprising:
a substrate:
an underlayer; and
a primer layer coated with metal coating.

The present invention also provides a method for manufacturing a thin metal electrode film:
step (a): forming an underlayer on a substrate,
step (b): structuring a primer layer, which optionally contain metal precursor, on the underlayer,
step (c): optionally subjecting the primer layer to development,
step (d): hard baking the primer layer obtained in step (c), and
step (e) carrying out metal plating on the primer layer.

It has been surprisingly found that by incorporating an underlayer in the structure of the thin metal electrode film, the defects on the surface of the substrate no longer affect the plated metal layer. Consequently, it is possible to form thin metal electrode film having metal wiring with high resolution on a substrate, which has excellent electrical properties and can be used in various electronic devices.

### DESCRIPTION OF FIGURES

The present invention will be described with reference to the figures, which are not intended to limit the present invention.
Fig. 1 is optical microscopic images showing (a) primer pattern without the underlayer, (b) primer pattern on the underlayer fabricated via i-CVD, (c) primer pattern fabricated on the underlayer via ultrasonic spray method and (d) primer pattern on the underlayer fabricated via slot-die method.
Fig. 2 shows TEM pictures of randomly dispersed nanosized Ag seeds.

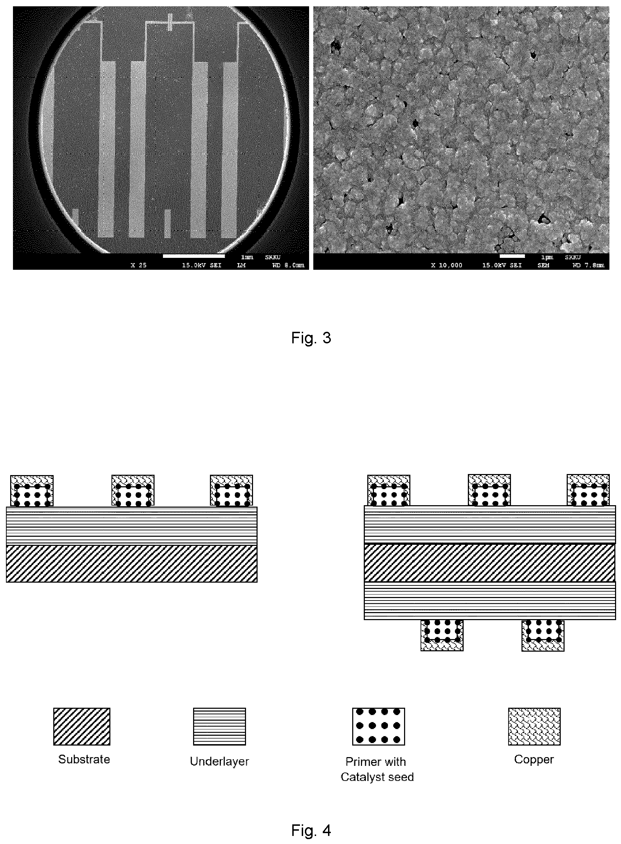

Fig. 3 shows SEM pictures of fine Cu patterns and the surface of the Cu patterns after electroless plating.
Fig. 4 shows a cross-sectional diagram of the thin metal electrode films according to the present invention.

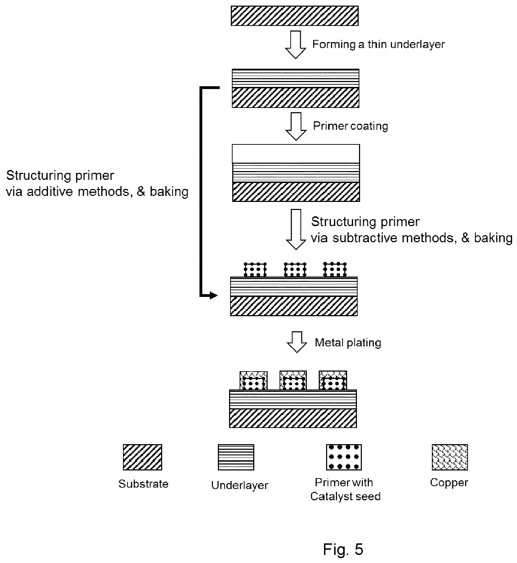

Fig 5 shows an example of the overall process for manufacturing thin metal electrodes films.

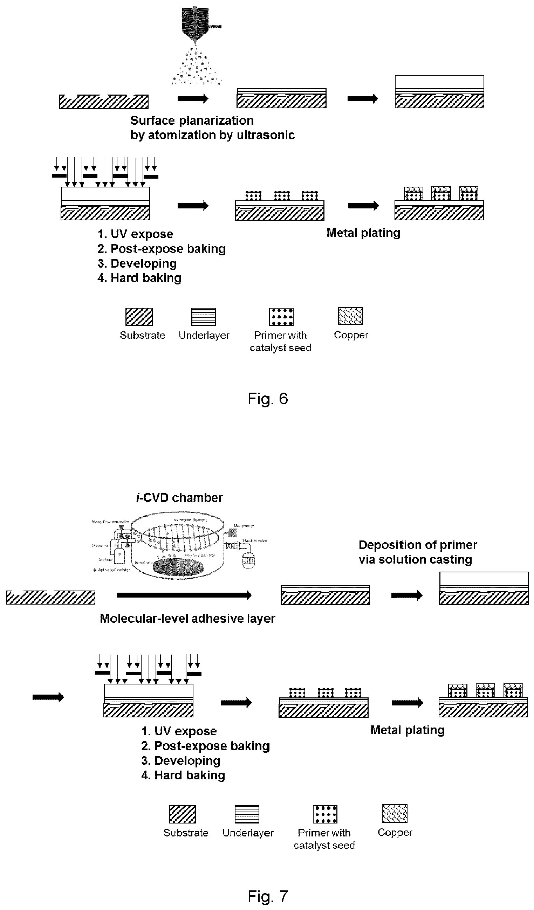

Fig. 6 shows one embodiment of the aerosol-based deposition of underlayer and subtractive structuring of primer according to the present invention.
Fig. 7 shows another embodiment of the vapor-phase deposition of underlayer and subtractive structuring of primer according to the present invention.

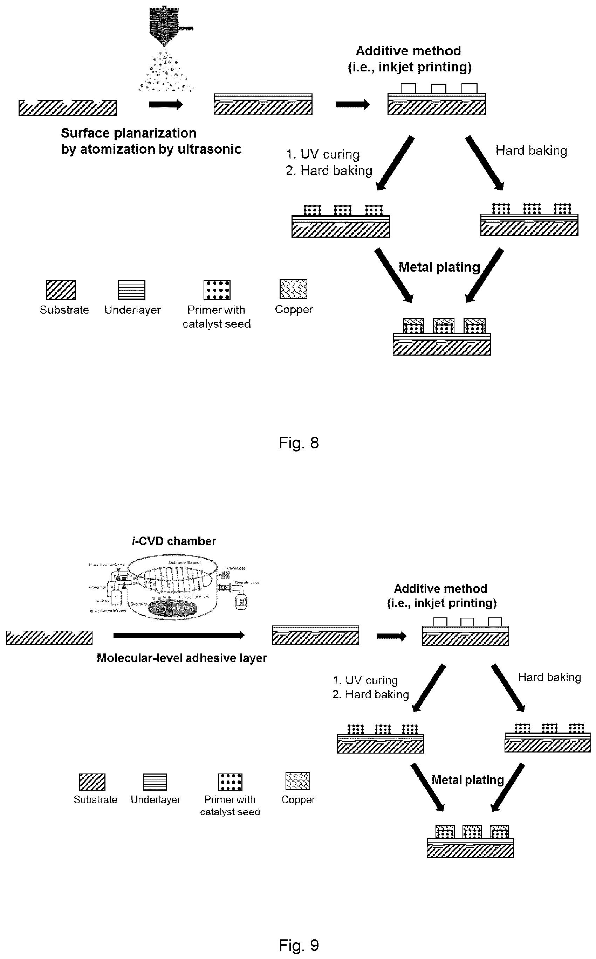

Fig. 8 shows one embodiment of the aerosol-based deposition of underlayer and additive structuring of primer according to the present invention.
Fig. 9 shows another embodiment of the vapor-phase deposition of underlayer and additive structuring of primer according to the present invention.

### MODE OF CARRYING OUT THE INVENTION

Unless defined otherwise, all technical and scientific terms used herein have the meaning commonly understood by a person skilled in the art to which the invention belongs.

In one aspect, the invention provides a thin metal electrode film comprising:
a substrate:
an underlayer; and
a primer layer coated with metal coating.

### Substrate

In the present invention, the substrate can be polyamides (i.e., PA6/66, PA-6-3-T), polyethylene terephthalate (PET), poly(methyl methacrylate) (PMMA), polystyrene (PS), acrylonitrile butadiene styrene (ABS), styrene-acrylonitrile (SAN), polyvinyl chloride (PVC), phenol formaldehyde (PF), polymethylpentene (PMP), polyphthalamide (PPA), polyimide (PI), polytetrafluoroethylene (PTFE), polybenzimidazole (PBI), thermoplastic polyimide (TPI), polyetherimide (PEI), polysulfone (PSU), poly(p-phenylene oxide) (PPO), polyvinylidene fluoride (PVDF), polyphenylsulfone (PPSU), polyethersulfone (PES), polyetherketone (PEK), polyether ether ketone (PEEK), polyethylene naphthalate (PEN), polybutylene terephthalate (PBT), polyoxymethylene (POM), liquid-crystal polymer (LCP), polyphenylene sulfide (PPS), polycarbonate (PC), or synthetic polymer-based substrates, without limitation, such as polyacetates, polyvinyllacetates, polyacrylamide polyethylene glycols, polylactic acids, polyglycolic acids, polylactide-co-glycolides, polyvinyl alcohols (PVA), polyvinyl pyrrolidones (PVP), quaternary amine-substituted polymers, polypropylenes (PP), polysiloxanes, synthetic elastomers, organic polymers, or copolymers thereof or combinations of any of these.

In other embodiments, the substrate can be natural polymers such as polysaccharides, proteins, nucleic acids or organic polymers.

### Underlayer

The underlayer may be formed with a polymer resin or polymerizable compound comprising polymerizable moiety that polymerizes under photo-initiating or heating.

Examples of the polymer resin include silicone resins, polyester resins, polyether resins, epoxy resins, urethane resins, alkyd resins, spiroacetal resins, polybutadiene resins, polythiol-polyene resins, and oligomers or polymer resins of (meth)acrylate. The term (meth)acrylate means acrylates and/or methacrylates, and "(meth)" has the same meaning with respect to the invention.

Examples of epoxy resins are bisphenol type epoxy resins such as bisphenol A type epoxy resin, bisphenol F type epoxy resin, and bisphenol S type epoxy resin; novolak type epoxy resins such as phenol novolak type epoxy resin, cresol novolak type epoxy resin, and bisphenol A novolak type epoxy resin; alicyclic epoxy resins; aliphatic chain epoxy resins; diglycidyl ether compounds of bisphenol; diglycidyl ether compounds of naphthalene diol; diglycidyl ether compounds of phenol; diglycidyl ether compounds of alcohols; and their alkyl-substituted compounds, halogenated compounds, and hydrogenated compounds; however the epoxy resins are not limited to these examples. One kind of epoxy resin may be used alone or in a mixture of two or more kinds of epoxy resins. As a polymerization initiator to be used together with the epoxy resins, any agents may also be used without particular limit if they can cure the epoxy resins. Examples of the curing agents are polyfunctional phenols, polyfunctional alcohols, amines, imidazole compounds, acid anhydrides, organic phosphorus compounds and their halides; however the curing agents are not limited to these examples. One kind of epoxy resin curing agent may be used alone or in a mixture of two or more kinds of epoxy resin curing agents.

Said compounds comprising polymerizable moiety may be selected from the group consisting of (meth)acrylate monomers, (meth)acrylonitrile monomers, styrene monomers, vinyl alkanoate monomers, monoethylenically unsaturated di-and tricarboxylic ester monomers, a compound having cyclic ether structure and a compound having 2 or more hydroxy groups or carboxy groups, and hydrophilic monomers such as vinyl alcohol, vinylpyrrolidone, acrylamide, ethylene oxide, ethylene imine, 4-vinylphenol, 4-vinylpyridine and 4-vinylimidazole.

Particularly, the (meth)acrylate monomers may be C₁-C₁₉-(cyclo)alkyl (meth)acrylates, for example, but not limited to, methyl (meth)acrylate, ethyl (meth)acrylate, n-butyl (meth)acrylate, 2-ethylhexyl (meth)acrylate, cyclohexyl (meth)acrylate, n-octyl (meth)acrylate, n-decyl (meth)acrylate, n-dodecyl (meth)acrylate (i.e. lauryl (meth)acrylate), tetradecyl (meth)acrylate, oleyl (meth)acrylate, palmityl (meth)acrylate, stearyl (meth)acrylate, isobornyl (meth)acrylate; benzyl (meth)acrylate, and phenyl (meth)acrylate; C₁₋C₁₀-alkoxyalkyl (meth)acrylates, for example, but not limited to, ethoxyethyl (meth)acrylate. Preferably, the (meth)acrylate monomers are C₁-C₁₂-(cyclo)alkyl (meth)acrylates, such as methyl (meth)acrylate, ethyl (meth)acrylate, n-butyl (meth)acrylate, 2-ethylhexyl (meth)acrylate, cyclohexyl (meth)acrylate, n-octyl (meth)acrylate, lauryl (meth)acrylate. Other compounds comprising polymerizable moiety that may be mentioned are, for example, (meth)acrylic acid, itaconic acid, fumaric acid, citraconic acid, sorbic acid, cinnamic acid, glutaconic acid and maleic acid; monoethylenically unsaturated carboxylic anhydride, such as itaconic acid anhydride, fumaric acid anhydride, citraconic acid anhydride, sorbic acid anhydride, cinnamic acid anhydride, glutaconic acid anhydride and maleic acid anhydride; monoethylenically unsaturated amides, especially N-alkylolamides, such as (meth)acrylamide, N-methylol (meth)acrylamide, 2-hydroxyethyl (meth)acrylamide; and hydroxyalkyl esters of monoethylenically unsaturated carboxylic acids, such as hydroxyethyl (meth)acrylate and hydroxypropyl (meth)acrylate.

Particularly, the styrene monomers may be unsubstituted styrene or substituted styrenes, for example, but not limited to, styrene, α-methylstyrene, ortho-, meta- and para-methylstyrene, ortho-, meta- and para-ethylstyrene, o,p-dimethylstyrene, o,p-diethylstyrene, isopropylstyrene, o-methyl-p-isopropylstyrene, nitrostyrene, aminostyrene, trifluoromethyl styrene or any mixtures thereof.

Particularly, the vinyl alkanoate monomers may be vinyl esters of C₂-C₁₁-alkanoic acids, for example, but not limited to, vinyl acetate, vinyl propionate, vinyl butanoate, vinyl valerate, vinyl hexanoate, vinyl versatate or a mixture thereof.

The monoethylenically unsaturated di-and tricarboxylic ester monomers may be full esters of monoethylenically unsaturated di- and tricarboxylic acids, for example, but not limited to, diethyl maleate, dimethyl fumarate, ethyl methyl itaconate, dihexyl succinate, didecyl succinate or any mixtures thereof.

The cyclic ether structure includes such as glycidyl (also known as epoxy) unit, oxetane unit, vinyl ether structure and vinyl thioether structure, and the like. The polymerizable compound having glycidyl unit is not specifically limited and compounds having 1 to 6, or 2 to 4 glycidyl units can be used. The polymerizable compounds having glycidyl unit include compounds having 2 or more glycidyl ether structures.

Specific examples of the polymerizable compound having glycidyl unit that can be mentioned are 1,4-butanediol glycidyl ether, 1.2-epoxy-4-(epoxyethyl)cyclohexane, glycerol triglycidyl ether, diethylene glycol diglycidyl ether, 2,6-diglycidyl phenyl glycidyl ether, 1,1,3-tris-(2,3-epoxypropoxy)phenylpropane, 1.2-cyclohexane dicarboxylic acid diglycidyl ester, 4,4'-methylenebis(N,N-diglycidylaniline), 3,4-epoxy cyclohexylmethyl-3,4-epoxycyclohexane carboxylate, trimethylol ethane triglycidyl ether, triglycidyl-p-aminophenol, tetraglycidyl metaxylenediamine, tetraglycidyl diaminodiphenyl methane, tetraglycidyl-1,3-bisaminomethylcyclohexane, bisphenol-A-diglycidyl ether, bisphenol-S-diglycidyl ether, pentaerythritol tetraglycidyl ether, resorcinol diglycidyl ether, phthalic acid diglycidyl ester, neopentylglycol diglycidyl ether, polypropylene glycol diglycidyl ether, tetrabromo bisphenol-A-diglycidyl ether, bisphenol hexafluoroacetone diglycidyl ether, pentaerythritol diglycidyl ether, tris-(2,3-epoxypropyl)isocyanurate, monoallyldiglycidyl isocyanurate, diglycerol polyglycidyl ether, pentaerythritol polyglycidyl ether, 1,4-bis(2,3-epoxypropoxyperfluoroisopropyl)cyclohexane, sorbitol polyglycidyl ether, trimethylolpropane polyglycidyl ether, resorcin diglycidyl ether, 1.6-hexanediol diglycidyl ether, polyethylene glycol diglycidyl ether, phenyl glycidyl ether, p-tert-butylphenylglycidyl ether, adipic acid diglycidyl ether, o-phthalic acid diglycidyl ether, dibromophenyl glycidyl ether, 1,2,7,8-diepoxyoctane, 1,6-dimethylolperfluorohexane diglycidyl ether, 4,4'-bis(2,3-epoxypropoxy- perfluoroisopropyl)diphenyl ether, 2.2-bis(4-glycidyloxyphenyl)propane, 3,4-epoxycyclohexylmethyl-3',4'-epoxycyclohexanecarboxylate, 3,4-epoxycyclohexyl oxirane, 2-(3,4-epoxycyclohexyl)-3',4'-epoxy-1,3-dioxane-5-spirocyclohexane, 1.2-ethylenedioxy-bis(3,4-epoxycyclohexylmethane), 4',5'-epoxy-2-methyl cyclohexylmethyl-4,5-epoxy-2-methylcyclohexane carboxylate, ethylene glycol-bis(3,4-epoxycyclohexane carboxylate), bis-(3,4-epoxycyclohexylmethyl) adipate, and bis(2,3-epoxycyclopentyl) ether, etc.

The polymerizable compound having oxetane unit is not specifically limited, and compounds having 1 to 6 or 2 to 4 oxetane units can be used. The polymerizable compound having oxetane unit includes, for example, 3-ethyl-3-hydroxymethyl oxetane, 3-ethyl-3-(phenoxymethyl)oxetane, 3.3-diethyl oxetane, and 3-ethyl-2-ethylhexyloxymethyl)oxetane, 1,4-bis(((3-ethyl 3-oxetanyl)methoxy)methyl)benzene, di((3-ethyl-3-oxetanyl)methyl)ether, and pentaerythritol tetrakis((3-ethyl-3-oxetanyl)methyl)ether, etc.

Compounds having 2 or more hydroxy groups or carboxy groups include such as a diol compound, a triol compound, a dicarboxylic acid compound, a tricarboxylic acid compound, and a glycidyl compound such as epichlorohydrin, etc.

The compound with polymerizable moiety shall have a melting temperature of below 40 °C and a weight average molecular weight of 100 or more.

When polymerizable compound comprising polymerizable moiety is used to form the underlayer, at least one radical initiator is required. The initiator is usually used in an amount of no more than 10% by weight, preferably 0.02 to 5% by weight, more preferably 0.1 to 1.5 wt%, based on the total weight of polymerizable compound and initiator. The initiator may be a thermal initiator or a redox initiator. Suitable thermal initiators include, but not limited to, inorganic peroxides such as hydrogen peroxide, or peroxodisulfates such as mono- or di-alkali metal or -ammonium salts of peroxide disulfuric acid, for example, its mono- and di-sodium, -potassium or -ammonium salts, or organic peroxides, such as alkyl hydroperoxides, for example tert-butyl, p-menthyl or cumyl hydroperoxide, tert-butyl perpivalate, and dialkyl or diaryl peroxides, such as di-tert-butyl or di-cumyl peroxide, 2,5-dimethyl-2,5-di-t-butylperoxyhexane or dibenzoyl peroxide; or azo compounds, which, in principle, are 2,2'-azobis(isobutyronitrile), 2,2'-azobis(2,4-dimethylvaleronitrile), 2,2'-azobis(amidinopropyl) dihydrochloride (AlBA, such as V-50TM from Wako Chemicals), 1,1'-azobis(1-cyclohexanecarbonitrile), 2,2'-azobis(2-amidinopropane)salts, 4,4'-azobis(4-cyanovaleric acid) or 2-(carbamoylazo)isobutyronitrile. Suitable redox initiator usually comprises an oxidizing agent and a reducing agent. Suitable oxidizing agents are the abovementioned peroxides. Suitable reducing agents may be alkali metal sulfites, for example potassium and/or sodium sulfite, or alkali metal hydrogensulfites, for example potassium and/or sodium hydrogensulfite, or alkali metal metabisulfites, for example potassium and/or sodium metabisulfite, or formaldehyde sulfoxylates, for example potassium and/or sodium formaldehyde sulfoxylate, or alkali metal salts, specifically potassium and/or sodium salts, of aliphatic sulfinic acids, or alkali metal hydrogen sulfides, for example, potassium and/or sodium hydrogen sulfide, or acetone bisulfites, for example sodium acetone bisulfite (2-hydroxy-2-propanesulfonic acid monosodium salt), ascorbic acid, or isoascorbic acid. Preferable redox initiators include an oxidizing agent selected from the group consisting of t-butylhydroperoxide and hydrogen peroxide, and a reducing agent selected from the group consisting of ascorbic acid, sodium formaldehyde sulfoxylate, sodium acetone bisulfite and sodium metabisulfite (sodium disulfite).

The underlayer may also contain at least one crosslinker. The crosslinker may help to improve the mechanical properties of the underlayer. Many crosslinkers may be used, which includes, but not limited to polyfunctional azide compounds with at least two azide functional groups and polyfunctional aziridine compounds with at least two aziridine functional groups. The crosslinker is usually used in an amount of no more than 10% by weight, preferably 0.02 to 5% by weight, more preferably 0.1 to 1.5 wt%, based on the total weight of polymerizable compound and crosslinker.

The polyfunctional azide compounds are not particularly limited, generally including hydrophilic organic azido groups, hydrophobic organic azido groups (also including amphiphilic organic azido groups), di-azido organic crosslinking groups, and azide-substituted aromatic derivatives, for example including any of the structures illustrated in Formula 1-6. Examples of suitable azide-substituted organic compounds include azide-substituted polyoxyalkylenes, azide-substituted organic amines (and ammonium salts thereof), azide-substituted organic amides, azide-substituted organic imines, azide-substituted carboxylic acids, azide-substituted carbonyl-containing compounds (e.g., ketones, carboxylic acids, carboxylate salts or esters), azide-substituted alkyl polyoxyalkylenes, azide-substituted alcohols, azide-substituted alkanes, azide-substituted alkenes, diazido alkanes, and azide-substituted dyes.

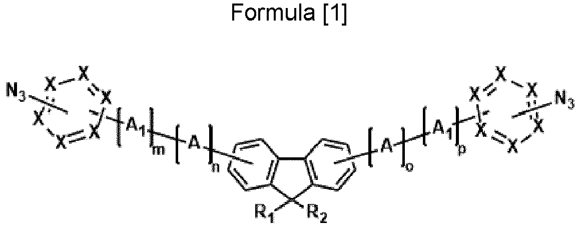

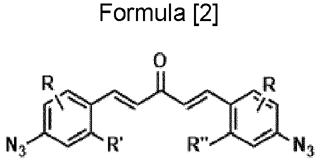

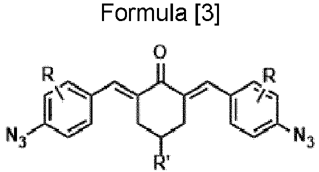

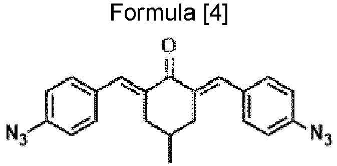

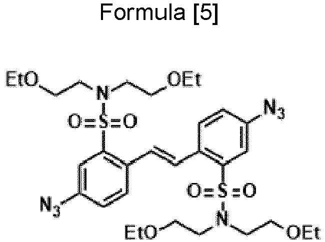

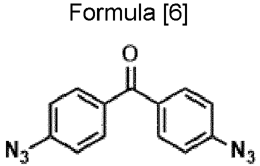

In the formula, R, R', R", R₁ and R₂ can be independently selected from hydrogen atoms, oxygen atoms, nitrogen atom, fluoride, sulfur atom, SO₃Na, substituted or unsubstituted saturated aliphatic groups of C₁∼C₃₀, substituted or unsubstituted unsaturated aliphatic groups of C₁∼C₃₀;
m, n, o and p can be independently 0,1 and 2;
A and A₁ can be at least one of groups selected from ether bond, ester bond, amide bond, double bond, triple bond, substituted or unsubstituted aromatic groups of C₆∼C₂₀, substituted or unsubstituted hetero-aromatic groups of C₆∼C₂₀, the substituent being independently selected from -NR₁R₁, -OR₁, -SR₁ and -SiR₁R₂; and x can be at least one or more carbon with fluorine atom as substituent.

The aziridine functional groups have the following general structure, or are derived therefrom:

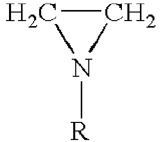

In the above formula, one or both of the CH₂ moieties on the aziridine functional group may be substituted, for example, with methyl or higher alkyl groups. A variety of polyfunctional aziridine compounds are suitable to crosslink the carboxylic acid moieties in the present invention. Typically, the aziridine compounds include from 3 to 5 nitrogen atoms per molecule. Examples include N-(aminoalkyl) aziridines such as N-aminoethyl-N-aziridilethylamine, N,N-bis-2-aminopropyl-N-aziridilethylamine, and N-3,6,9-triazanonylaziridine. Preferred crosslinking agents include bis- and tris-aziridines of di- and tri-acrylates of alkoxylated polyols, including the trisaziridine of the triacrylate of the adduct of glycerine and propylene oxide; the trisaziridine of the triacrylate of the adduct of trimethylolpropane and ethylene oxide; and the tris-aziridine of the triacrylate of the adduct of pentaerythritol and propylene oxide.

The underlayer can be structured by bottom-up gradient copolymerization having controlled surface energy, mechanical property and Young's modulus.

The underlayer may have a thickness in the range of 20 nm to 10 µm, or in the range of 50 nm to 8 µm, or in the range of 80 nm to 5 µm.

Without bonding to any specific theory, the underlayer may have multiple functions, such as serving as a dielectric layer, adhesive layer between substrate and the primer, surface adaptive layer for improving compatibility between substrate and surface flattening layer.

### Primer layer

The primer layer according to the present invention may be prepared from (a) an organic polymer resin, (b) a polyfunctional monomer having an ethylenically unsaturated bond, (c) a polymerization initiator and (d) optionally a metal organic complex precursor.

The organic polymer resin may be obtained via polymerization of monomers selected from (meth)acrylate monomers, (meth)acrylonitrile monomers, styrene monomers, vinyl alkanoate monomers, monoethylenically unsaturated di-and tricarboxylic ester monomers and the like. The monomer may be the same as or different from that used for the preparation of the underlayer.

As the polyfunctional monomer having an ethylenically unsaturated bond, there may be mentioned, for example: a compound obtained by esterification of a polyhydric alcohol with an α,β-unsaturated carboxylic acid, e.g., ethylene glycol diacrylate, ethylene glycol dimethacrylate, polyethylene glycol diacrylate having 2 to 14 ethylene groups, polyethylene glycol dimethacrylate having 2 to 14 ethylene groups, trimethylolpropane triacrylate, trimethylolpropane trimethacrylate, pentaerythritol triacrylate, pentaerythritol trimethacrylate, pentaerythritol tetraacrylate, pentaerythritol tetramethacrylate, propylene glycol diacrylate having 2 to 14 propylene groups, propylene glycol dimethacrylate having 2 to 14 propylene groups, dipentaerythritol pentaacrylate, dipentaerythritol pentamethacrylate, dipentaerythritol hexaacrylate or dipentaerythritol hexamethacrylate; a compound obtained by adding acrylic acid or methacrylic acid to a glycidyl-containing compound, e.g., a trimethylolpropane triglycidyl ether acrylic acid adduct or a bisphenol A diglycidyl ether acrylic acid adduct; or an ester compound of multi-carboxylic acid with a compound having hydroxyl group and ethylenically unsaturated bond or multi-isocyanate adduct of a compound having hydroxyl group and ethylenically unsaturated bond, e.g., a phthalate of β-hydroxyethyl acrylate or β-hydroxyethyl methacrylate or a toluene diisocyanate adduct of β-hydroxyethyl acrylate or β-hydroxyethyl methacrylate. These multi-functional monomers may be used alone or as a mixture of two or more thereof.

The polymerization initiator may be a thermal initiator or photo initiator. The initiator may be the same as or different from that used for the preparation of the underlayer.

The primer may optionally contain metal organic complex precursor. The metal organic complex precursor may be added into the resin composition as a catalyst precursor and acts as a catalyst for electroless plating to form an electromagnetic wave shielding layer. The metal organic complex precursors that can be used in the present invention include, but are not limited to acetate complexes (such as gold, silver or copper acetate), sulfonate complexes (such as gold, silver, platinum or copper sulfonate), β-carbonyl ketone complexes (such as gold, silver, platinum or copper β-carbonyl ketones), and β-carbonyl ester silver (I) complexes (such as gold, silver, platinum or copper β-carbonyl esters). The metal organic complex precursors may be used alone or as a mixture of two or more thereof.

Silver organic complex is the preferred metal organic complex precursor in the present invention. Examples of the silver organic complexes include, but are not limited to, silver acetate, silver lactate, silver myristate, silver citrate, silver benzoate, silver phenylacetate, silver cyclohexanebutyrate, silver p-toluenesulfonate, silver oxalate, silver malonate, silver succinate, and silver adipate. Examples of the β-carbonyl ketone silver (I) complexes and β-carbonyl ester silver (I) complexes include, but are not limited to, silver (I) acetylacetonate, 3-chloro-2,4-pentanedionato silver (I), 3,5-heptanedionato silver (I), 2-acetylcyclohexanonato silver (I), 3-ethyl-2,4-pentadionato silver (I), benzoylacetone silver (I), dibenzoylmethane silver (I), 2,2,6,6-tetramethylheptanediene silver (I), ethylacetoacetate silver (I), methylacetoacetate silver (I), isopropylacetoacetate silver (I) and tert-arylbutylacetoacetate silver (I) complexes. As silver fluoride organic complex, there may be used, for example, silver (I) fluorosulfate, silver (I) trifluoroacetate, silver (I) trifluoromethanesulfate, silver (I) pentafluoropropionate, or silver (I) heptafluorobutyrate. Examples of suitable silver fluoride organic complexes include 1,5-cyclooctadiene-hexafluoroacetylacetonato silver (I), 1,1,1-trifluoro- 2,4-pentadionato silver (I), 5,5-dimethyl-1,1,1-trifluoro-2,4-hexanedionato silver (I), 1-(4-methoxyphenyl)-4,4,4-trifluorobutanedionato silver (I), 5,5,6,6,7,7,8,8,9,9,10,10,11,11,12,12,12-heptadecafluorodecane-2,4-dionato silver (I), 1,1,1,2,2,3,3-heptafluoro-7,7-dimethyl-4,6-octanedionato silver (I), 1,1,1,3,5,5,5-heptafluoropentane-2,4-dionato silver (I), 1,1,1,5,5,5-hexafluoropentane-2,4-dionato silver (I), 5,5,6,6,7,7,8,8,8-nonafluorooctane-2,4-dionato silver (I), 5H,5H-perfluorononane- 4,6-dionato silver (I), 6H,6H-perfluoro-undecane-5,7-dionato silver (I), 8H,8H-perfluoropentadecane-7,8-dionato silver (I), 6H,6H-perfluoroundecane-5,7-dionato silver (I), 1-phenyl-2H,2H-perfluorohexane-1,3-dionato silver (I), 1-phenyl-2H, 2H-perfluoroundecane-1,3-dionato silver (I), 5,6,6,6-tetrafluoro- 5-(heptafluoropropoxy)hexane-2,4-dionato silver (I), 1,1,5,5-tetrafluoropentane- 2,4-dionato silver (I), 5,5,6,6,7,7,8,8,9,9,9-undecanefluoro-nonane-2,4-dionato silver (I), ethyl-3-chloro-4,4,4-trifluoroacetoacetato silver (I), ethyl-4,4-difluoroacetoacetato silver (I), ethyl-4,4,4-trifluoroacetoacetato silver (I), isopropyl- 4,4,4-trifluoroacetoacetato silver (I), methyl-4,4,5,5,5-pentafluoro-3-oxopentanonato silver (I), ethyl-4,4,5,5,5-pentafluoro-3-oxo-pentanonato silver (I) and 1,1,1,5,5,6,6,6-octafluoro-2,4-hexanedionato silver (I) complexes. These silver fluoride organic complexes may be used alone or as a mixture of two or more thereof.

### Method

In another aspect, the present invention provides a method for manufacturing a thin metal electrode film comprising:
step (a): forming an underlayer on a substrate,
step (b): structuring a primer layer, which optionally contain metal precursor, on the underlayer,
step (c): optionally subjecting the primer layer to development,
step (d): hard baking the primer layer obtained in step (c), and
step (e) carrying out metal plating on the primer layer.

Step (a) can be carried out by method selected from vapor-phase deposition, aerosol-based deposition and solution-casting. Specifically, the aerosol-based deposition methods include, but are not limited to electrostatic spray, ultrasonic spray, or typical spray methods. Specifically, the solution-casting methods include, but are not limited to slot-die coating, spin-coating and doctor-blade coating.

Step (b) can be carried out by additive method or subtractive method, which are known in the art.

The additive method for structuring primer is a printing process, which can be selected from inkjet printing, gravure printing, reverse gravure printing, flexographic printing, offset printing, screen printing, stamping, laser-induced transfer printing, thermally induced transfer printing.

In some embodiments, in printing processes, exposure to light can be carried out without a predetermined photomask. In this invention, it is preferred to use the i-line (365 nm), h-line (405 nm) or g-line (436 nm) of a mercury lamp. The structured primer by printing methods can also be baked without developing by alkali solution or solvent.

In other embodiments, in printing processes, the structured primer is directly polymerized by heat. In this case, it is preferred to use a temperature ranging from 100 °C to 300 °C and time ranging from one minute to 30 minutes, more preferably less than 10 minutes.

The subtractive method for structuring primer is a photolithography process, which is integrated with aerosol-based deposition (i.e., electrostatic spray coating, ultrasonic spray coating, typical spray coating methods) or solution-casting methods (i.e., slot-die coating, spin-coating, doctor-blade coating). In photolithography processes, exposure to light can be carried out with a predetermined photomask. It is preferred to use the i-line (365 nm), h-line (405 nm) or g-line (436 nm) of a mercury lamp.

In one embodiment, the primer does not include metal precursors, and imparting electroless plating catalysts such as metal precursor or metallic colloid to primer is needed. Examples of the method for imparting the electroless catalyst to the primer can be selected from dipping methods but are not limited to these. The catalysts can be adsorbed by an interactive group on the primer layer through an inter-ion interaction or a dipole-ion interaction. In order to achieve sufficient adsorption or impregnation, the concentration of the catalysts in the dipping bath is preferably in a range of 1 to 50 weight %, and more preferably in the range of 1 to 30 weight %. The length of time required for the dipping is preferably approximately one minute to 24 hours, and more preferably approximately five minutes to one hour.

In step (c), development is carried out by using a developer. For example, in case where a positive type primer is used, the development results in removal of exposed part of the primer and forming of primer pattern, or in case where a negative type primer is used, the development results in removal of unexposed part of the primer and forming of primer pattern. The developer is selected from alkali solution (pH 7 ∼ pH 14) or solvent. If necessary, a post exposure bake may be performed after being exposed to light. The post exposure bake is conducted under a heating temperature suitably selected from 70 to 100 °C, with a heating time of 0.3 to 10 minutes.

The developer includes for example a tetramethylammonium aqueous solution or an aqueous solution of a compound showing alkalinity such as diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine or hexamethylenediamine. To the alkaline aqueous solution, any one or more of the following can also be added: polar solvents such as N-methyl-2-pyrrolidone, N,N-dimethylformamide, N,N-dimethylacetamide, dimethyl sulfoxide, γ-butyrolactone and dimethylacrylamide, alcohols such as methanol, ethanol and isopropanol, esters such as ethyl lactate, propylene glycol monomethyl ether acetate, ketones such as cyclopentanone, cyclohexanone, isobutyl ketone and methyl isobutyl ketone. The developed primer is treated by rinsing with water. In this case, an alcohol such as ethanol or isopropyl alcohol or an ester such as ethyl lactate or propylene glycol monomethyl ether acetate can also be added to water for rinsing treatment. Additionally, surfactants can be added in the developer. The condition in which development takes place is suitably a temperature ranging from 5 to 50° C and time ranging from 0.1 to 5 minutes.

In step (d), hard baking can be performed at 50 °C to 300 °C for about 10 min.

In step (e), metal plating can be carried out by electroplating methods or electroless plating methods.

Electroless plating is performed in the presence of surface charge modifier or performed in electroless plating bath containing a specific amount of the plating catalyst poison, in order to form a highly finely-patterned metal wiring with a sufficient thickness.

The surface charge modifier may be allowed to act at any stage in the electroless plating process. The surface charge modifier may be added to the solution of the electroless plating bath for electroless plating treatment, or the surface of the substrate may be pretreated with the surface charge modifier before the electroless plating process.

The surface charge modifier is preferably an organic compound having, in its molecule, (i) a group having an affinity for the substrate and (ii) an ionic leaving group. If the electroless plating is performed in the presence of this surface charge modifier, a metallic film which has a high density and sufficient thickness and accords to the primer pattern can be formed on the pattern. As a result, the formed metallic pattern has high electrical conductivity and good adhesion.

In the electroless plating process, any method may be used to add the plating catalyst poison to the plating bath. A specific amount of the catalyst poison may be added to the electroless plating solution before the plating is started or after the plating is started. Alternatively, the plating catalyst poison may be added at a certain time interval such that the concentration of the plating catalyst poison in the solution of the electroless plating bath is maintained within a specific range or may be added as needed such that its concentration is maintained within a specific range while the concentration is measured.

The surface charge modifier used in the invention may be any compound as long as it is capable of being adsorbed to the base material surface and capable of inhibiting the adsorption of metal ions to the base material. An organic compound having (i) a group having an affinity for the substrate and (ii) an ionic leaving group (dissociable group) in its molecule is preferably used.

Herein, (i) the group having an affinity for the substrate includes a hydrophobic or lipophilic functional group. Preferable examples thereof include an alkyl group having 4 or more carbon atoms, an aromatic group having 6 or more carbon atoms, and a fluorinated alkyl group having 3 or more carbon atoms. Preferable examples of (ii) the ionic leaving group include a carboxyl group, an amino group, an ammonium group, and a sulfoxyl group. An organic compound having these functional groups in its molecule is preferred compound as the surface charge modifier.

For example, when an organic compound having an ammonium group is used, it is selectively adsorbed to the substrate surface so that the surface is positively charged. In this case, a surface potential of the substrate is preferably in a range of +0.1 mV to +500 mV, more preferably in a range of +1.0 mV to +100 mV. The region with such a positively-charged surface is resistant to a deposition of metal ions (such as Cu²⁺) from the plating bath, and thus the metal ions are selectively deposited only on the region that has the plating catalyst (or precursor) attached to the patterned graft polymer.

Examples of the plating catalyst poison used in the electroless plating according to the invention include metal ions, inorganic anions, an organic compound having a group having an affinity for a plating metal in its molecule, and an organic compound having a group having an affinity for plating metal and an ionic leaving group in its molecule.

Examples of metal ions serving as the plating catalyst poison for use in the invention include metal ions selected from ions of any one of Pb, Sn, As, Sb, Bi, Cr, Mo, Cd, In, Tl, W, Nb, and Ti. Preferable metal ions are appropriately selected depending on the species of the metal used in the electroless plating. When copper, silver or gold is used as the plating metal, metal ions of Pb, Sn, Sb, or Bi are preferably used. Examples of the inorganic anions serving as the plating catalyst poison include an iodine anion, a bromine anion and a sulfide anion, and an iodine anion is particularly preferable.

Examples of the organic compound having, in its molecule, a group having an affinity for plating metal include organic compounds having a functional group having an affinity for plating metal and a substituent selected from an alkyl group, an aryl group, and a heterocyclic group, as listed below.

Examples of the group having an affinity for plating metal include a carboxyl group, a carbonyl group, an amino group, a mercapto group, and a thiocarbonyl group. Preferable examples of the functional group depend on the species of the plating metal. When the plating metal is a good electrical conductor such as copper, silver or gold, a mercapto group or a thiocarbonyl group is preferable.

Examples of sulfur-containing organic compounds having a mercapto group or a thiocarbonyl group for use as the plating catalyst poison include thiol compounds, compounds convertible into thiol compounds due to tautomerism, disulfides, thioamides, and thioureas.

Examples of the thiol compounds include thiocyanuric acid, 2-mercaptothiazoline, 2-mercaptopyridine, 2-mercaptobenzothiazole, and 2-phenyl-5-mercaptotetrazole. Examples of the compounds convertible into thiol compounds by tautomerism include 2-thiobarbituric acid, 2-imidazolidinethione, 1-phenyl-2-tetrazoline-5-thione, and 2-thiouracil.

Examples of the disulfides include dibenzothiazyl disulfide and tetramethylthiuram disulfide.

Examples of the thioamides include N-tert-butyl-2-benzothiazolyl sulfenamide. Examples of the thioureas include thiourea, methylthiourea, and octylthiourea.

The organic compound having a group having an affinity for plating metal in its molecule for use as the plating catalyst poison may further have an ionic substituent in its molecule. Herein, the ionic substituent includes a carboxyl group, an amino group, an ammonium group, a sulfoxyl group and the like.

Examples of the organic compound having a group having an affinity for plating metal and an ionic leaving group in its molecule include 2-(3-carboxyl-phenyl)-5-mercaptotetrazole, 2-(3-sulfoxyl-phenyl)-5-mercaptotetrazole, thiosalycilic acid, 2-(3-(2-aminoethyl)-phenyl)-5-mercaptotetrazole, sodium 2-mercaptobenzothiazole-5-sulfonate, and sodium 2-(2-mercaptobenzothiazolyl)ethanesulfonate.

The amount of the plating catalyst poison added to the electroless plating solution for use in the invention should be adjusted such that the concentration of the plating catalyst poison in the electroless plating solution is set in a range of 1×10⁻¹⁰ to 1×10⁻⁵ mol/l, more preferably in a range of 1×10⁻⁷ to 5×10⁻⁶ mol/l.

The plating catalyst poison may be added in a form of a solution thereof to the electroless plating solution. The plating catalyst poison may be preliminarily added to the electroless plating solution to provide a specific concentration or may be added at once at a time when a certain period passed after the electroless plating is started.

It is well known that when no plating catalyst poison is added, plating rate (or deposition rate of plating metal) is generally low at the initial stage of plating and then increases as the plating proceeds. Thus, the latter process, that includes stating plating with no addition of an effective concentration of the catalyst poison and then adding the compound serving as the catalyst poison to provide a concentration in the above range when a certain period passed after the electroless plating is started, is a preferable mode of the process that includes adding the plating catalyst poison to the electroless plating bath to form the electroless plating solution with a concentration in the above range.

In the invention, generally-known electroless plating may be performed except that it further includes the addition of the plating catalyst poison to the plating bath.

A time length of the immersion in the plating bath containing the plating catalyst poison is preferably in a range of about 1 minute to about 3 hours, more preferably in a range of about 1 minute to about 1 hour. In conventional methods, an extended time length of the immersion in plating baths or an increase in metal ion concentration of plating baths further promotes growth of metallic films in undesired directions of pattern width so that it is difficult to form desired very fine patterns of metal. According to the method of the invention. However, metallic films are grown selectively in the thickness direction, so that metallic films with sufficient thickness can be obtained with no limitation relating to processes and that very fine patterns of metal with sufficient thickness can be easily formed.

Any conventionally-known method may be used as the electroplating process in the invention. Metals used in the electroplating in this process include copper, chromium, lead, nickel, gold, silver, tin, zinc, and the like, and copper, gold, and silver are preferable, and copper is more preferable from the point of conductivity.

A thickness of the metallic film obtained after electroplating varies according to applications and can be controlled by adjusting the concentration of the metal contained in the plating solution, time length of immersion, electric current density and the like. The thickness of common metallic films used for electric wiring or the like is preferably 0.5 µm or more and more preferably 3 µm or more from the point of conductivity.

The present invention will now be described with reference to the following examples, which are not intended to limit the present invention.

### Example

### Starting materials:

polyimide film substrate, Kapton polyimide film, from Dupont
1-vinlylimidazole, from Sigma Aldrich
4-vinylpyridine (4VP), from Sigma Aldrich
4-vinlyphenol, from Sigma Aldrich
tert-butyl peroxide (TBPO), from Sigma Aldrich
poly(4-vinylpyridine), from Sigma Aldrich, (Mw ∼ 160,000)
1-methoxy-2-propanol, from Sigma Aldrich
poly(methyl methacrylate), from Sigma Aldrich, (Mw ∼ 120,000)
2,6-bis(4-azidobenzylidene)cyclohexanone, from TCI.
propylene glycol methyl ether (hereinafter as "PGME"), from Sigma Aldrich
bisphenol A ethoxylate diacrylate, from Sigma Aldrich
dipentaerythritol penta-/hexa-acrylate, from Sigma Aldrich
poly(4-vinylphenol), from Sigma Aldrich, (Mw ∼ 25,000)
AgNO₃, from Sigma Aldrich
Irgacure Oxo-01, from BASF
tetramethylammonium hydroxide, from Sigma Aldrich

### Test Methods:

The optical microscopic images are obtained with ZEISS instrument. The SEM image is obtained with Hitachi High-Tech instrument. The TEM image is obtained with Hitachi High-Tech instrument.

### Experiments:

Experiment 1: Preparation of underlayer via i-CVD ("Underlayer 1") 1-vinlylimidazole, 4-vinylpyridine (4VP), 4-vinlyphenol and tert-butyl peroxide (TBPO) were used as monomer and radical initiator, respectively. Vaporized monomers and initiator were fed into an i-CVD chamber (Daeki Hi-Tech Company, Korea) for the vapor phase polymerization of monomers. The flow rate of each monomers and TBPO was set to 6 and 1 sccm, respectively. The polyimide film substrate temperature, the filament temperature, and the reactor pressure were kept at 100 °C, 200 °C, and 900 mTorr, respectively. The polyimide film substrate has a film size of 10 cm x 10 cm. The resulted underlayer film has a thickness of about 250 nm.

### Experiment 2: Preparation of underlayer via ultrasonic spray ("Underlayer 2")

To prepare a stock blend, poly(4-vinylpyridine), poly(methyl methacrylate) and 2,6-bis(4-azidobenzylidene)cyclohexanone were dissolved in 1-methoxy-2-propanol for stirred in dark for 2 hours. The resulted stock blend contains 20 wt% poly(4-vinylpyridine), 3 wt% poly(methyl methacrylate) and 4 wt% 2,6-bis(4-azidobenzylidene)cyclohexanone .

The stock blend (1.5 g) was diluted by PGME. Then the diluted blend (2 wt% solid content) was spray-casted via an ultrasonic spray method (supplied by Ultrasonic systems, Inc., spray height: 20 ∼ 50 mm, spray speed varied from 100 ∼ 2500 mm with fluid pressure 50 mbar) on a polyimide film substrate (film size: 10 cm x 10 cm) and dried at 80 °C for 10 minutes. Then, the film was exposed to UV light (i-line) for 10 seconds and baked at 120 °C for 30 minutes. The resulted underlayer film had a thickness of about 100 nm.

### Experiment 3: Preparation of underlayer via spin-casting ("Underlayer 3")

The same stock blend (1 g) as prepared in experiment 2 was spun-casted (spin-coater: WS-650-23NPP (Laurell Technologies Corporation), 2500 rpm, 20 seconds) on a polyimide film (film size: 5 cm x 5 cm) and dried at 80 °C for one minute. After that, the thin layer was exposed to UV light (i-line) for 4 seconds and subjected to hard baking at 120 °C for 10 minutes. The resulted underlayer film had a thickness of about 100 nm.

### Experiment 4: Preparation of underlayer via slot-die coating ("Underlayer 4")

The same stock blend (0.5 g) as prepared in experiment 2 was casted by slot-die machine (Ossila Ltd UK, injection speed to slot-die head: 5 mL/min via a glass syringe fixed at automatic injector, coating speed on the stage: 15 mm/s) on a polyimide film (film size: 10 cm x 10 cm). The casted film was dried in a vacuum oven (80 °C, 5 minutes). After that, the thin layer was exposed to UV light (i-line) for 4 seconds and subjected to hard baking at 120 °C for 10 minutes. The resulted underlayer film had a thickness of about 5,000 nm.

### Experiment 5: Preparation of primer layer

Preparation of primer resin: bisphenol A ethoxylate diacrylate, dipentaerythritol penta-/hexa-acrylate and poly(4-vinylphenol) were dissolved in 1-methoxy-2-propanol, then silver nitrate was added to the blending. Finally, Irgacure Oxo-01 was added and further blended. The blend was stirred for 2 hours in the dark. The resulted primer resin contains 24 wt% bisphenol A ethoxylate diacrylate, 24 wt% dipentaerythritol penta-/hexa-acrylate, 2 wt% poly(4-vinylphenol) and 2 wt% Irgacure Oxo-01. The AgNO3 has a concentration of 0.1 M.

The prepared primer resin was spun-casted onto each of the prepared substrates (i.e. Underlayer 1, 2 and 4) and a blank substrate (i.e. polyimide film without a underlayer). In the spun-cast process, 1 g of the primer resin was used and spun-casted was performed at a speed of 2,000 rpm for 20 sec. Then, each spun-coated substrate was dried at 80 °C for one minute. After that, a photomask was placed on the film and exposed to UV light (i-line) for 4 seconds and carried out post-expose baking at 100 °C for one minute.

Then, developing by aqueous 2.38 wt% tetramethylammonium hydroxide (TMAH) was performed for 5 seconds and rinsed by water several times. Then, it was thermally baked in a hot oven (set to 150 °C in advance) for 10 minutes and cooled down to room temperature.

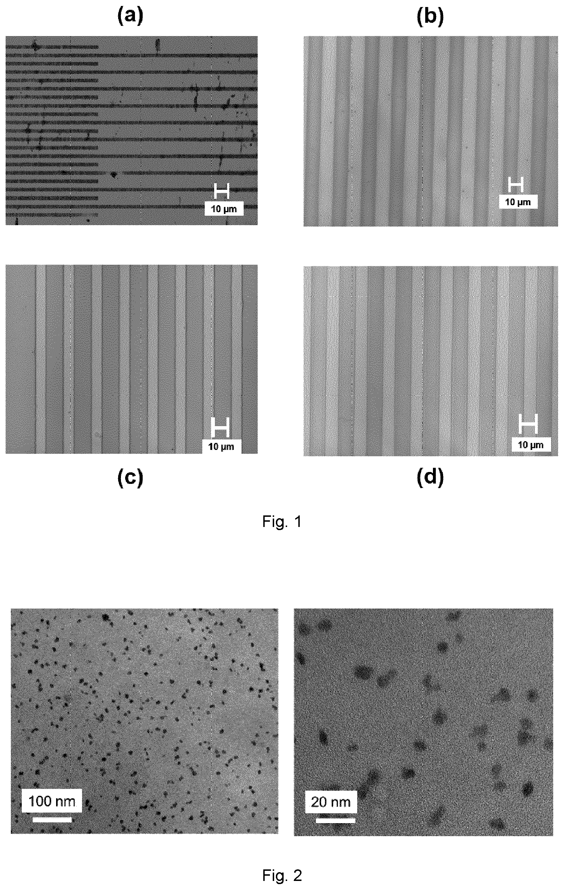

It is clear from Fig 1 that the primer layer formed on top of a substrate without a underlayer (Fig 1 (a)) shows significant defects. As a comparison, the primer layers formed on top of a substrate with an underlayer (Fig 1 (b)-(d)) have very smooth surface and finely formed pattern.

## Claims

1. A thin metal electrode film comprising:
a substrate;
an underlayer; and
a primer layer coated with metal coating.

2. The thin metal electrode film according to claim 1, wherein the underlayer is formed with polymer resin.

3. The thin metal electrode film according to claim 2, wherein the polymer resin is selected from the group consisting of silicone resins, polyester resins, polyether resins, epoxy resins, urethane resins, alkyd resins, spiroacetal resins, polybutadiene resins, polythiol-polyene resins, and oligomers or polymer resins of (meth)acrylate.

4. The thin metal electrode film according to claim 1, wherein the underlayer is formed with polymerizable compound comprising polymerizable moiety that polymerizes under photo-initiating or heating.

5. The thin metal electrode film according to claim 4, wherein the polymerizable compound comprising polymerizable moiety is selected from the group consisting of (meth)acrylate monomers, (meth)acrylonitrile monomers, styrene monomers, vinyl alkanoate monomers, monoethylenically unsaturated di-and tricarboxylic ester monomers, a compound having cyclic ether structure and a compound having 2 or more hydroxy groups or carboxy groups, and hydrophilic monomers such as vinyl alcohol, vinylpyrrolidone, acrylamide, ethylene oxide, ethylene imine, 4-vinylphenol, 4-vinylpyridine and 4-vinylimidazole.

6. The thin metal electrode film according to claim 4, wherein the underlayer also contains at least one crosslinker.

7. The thin metal electrode film according to claim 6, wherein the crosslinker is polyfunctional azide compound with at least two azide functional groups or polyfunctional aziridine compound with at least two aziridine functional groups.

8. The thin metal electrode film according to claim 7, wherein the polyfunctional azide compound includes hydrophilic organic azido groups, hydrophobic organic azido groups, di-azido organic crosslinking groups, or azide-substituted aromatic derivatives.

9. The thin metal electrode film according to claim 7, wherein the crosslinker has a structure of any of the following formula [1] to [6] 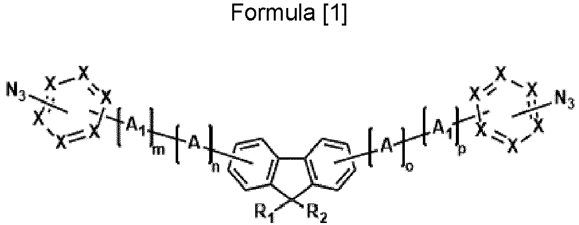 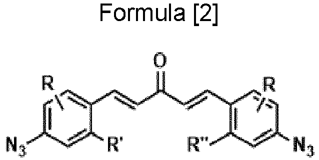 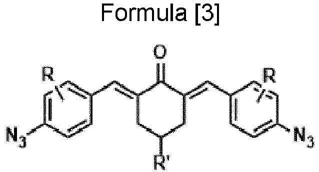 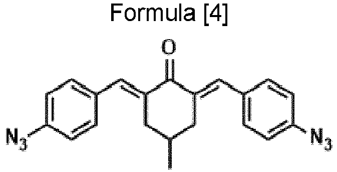 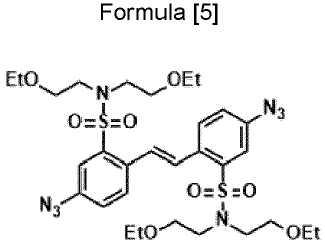 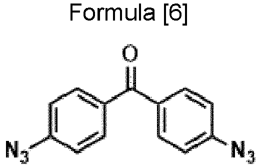 wherein R, R', R", R₁ and R₂ can be independently selected from hydrogen atoms, oxygen atoms, nitrogen atom, fluoride, sulfur atom, SO₃Na, substituted or unsubstituted saturated aliphatic groups of C₁∼C₃₀, substituted or unsubstituted unsaturated aliphatic groups of C₁∼C₃₀;
m, n, o and p can be independently 0,1 and 2;
A and A₁ can be at least one of groups selected from ether bond, ester bond, amide bond, double bond, triple bond, substituted or unsubstituted aromatic groups of C₆∼C₂₀, substituted or unsubstituted hetero-aromatic groups of C₆∼C₂₀, the substituent being independently selected from -NR₁R₁, -OR₁, -SR₁ and -SiR₁R₂; and x can be at least one or more carbon with fluorine atom as substituent.

10. The thin metal electrode film according to claim 6, wherein the crosslinker is bis- or tris- aziridine of di- or tri-acrylate of alkoxylated polyol.

11. The thin metal electrode film according to claim 6, wherein the crosslinker is used in an amount of no more than 10% by weight, preferably 0.02 to 5% by weight, more preferably 0.1 to 1.5 wt%, based on the total weight of polymerizable compound and crosslinker.

12. The thin metal electrode film according to claim 1, wherein the underlayer has a thickness in the range of 20 nm to 10 µm, or in the range of 50 nm to 8 µm, or in the range of 80 nm to 5 µm.

13. A method for manufacturing a thin metal electrode film comprising:
step (a): forming an underlayer on a substrate,
step (b): structuring a primer layer, which optionally contain metal precursor, on the underlayer,
step (c): optionally subjecting the primer layer to development,
step (d): hard baking the primer layer obtained in step (c), and
step (e) carrying out metal plating on the primer layer.

14. The method according to claim 13, wherein step (a) is carried out by method selected from vapor-phase deposition, aerosol-based deposition and solution-casting.
